# FASCICULE DE BREVET EUROPEEN

(11) **EP 2 547 186 B1**
(45) Date de publication et mention de la délivrance du brevet: **21.03.2018**
(21) Numéro de dépôt: 12305838.0
(22) Date de dépôt: 12.07.2012
(51) Int. Cl.: H05K 5/06, G01D 11/24, H03K 17/945, H03K 17/95

(54) **DISPOSITIF ÉLECTRONIQUE ET SON PROCÉDÉ DE FABRICATION**
ELEKTRONISCHES GERÄT SOWIE HERSTELLUNGSVERFAHREN DAFÜR
ELECTRONIC DEVICE AND MANUFACTURING PROCESS

(30) Priorité: 15.07.2011 FR 1156467
(43) Date de publication de la demande: 16.01.2013
(73) Titulaire: Senstronic (Société Par Actions Simplifiée), 67700 Saverne (FR)
(72) Inventeur: Franc, Joël, 67201 Eckbolsheim (FR); Kirchdoerffer, Rémy, 1117 Grancy (CH)
(74) Mandataire: Nuss, Laurent

(56) Documents cités:
- DE-A1- 19 504 608
- DE-C1- 19 832 533
- US-A- 6 025 562

## Description

La présente invention concerne le domaine des dispositifs électroniques dans lesquels, d'une part, une carte électronique est montée dans un boîtier et relié à un câble de connexion et, d'autre part, un matériau d'enrobage est mis en oeuvre pour protéger et isoler ladite carte, et pour garantir son blocage en position dans le boîtier.

Plus particulièrement, l'invention concerne un procédé de fabrication d'un dispositif électronique, notamment du type capteur ou détecteur, qui consiste essentiellement :
à fournir i) un boîtier tubulaire, préférentiellement de section circulaire, dont une première extrémité est obturée, ii) une carte électronique portant des composants adaptés et au moins un moyen de signalisation lumineuse, iii) un câble de connexion, iiii) une pièce d'obturation pourvue d'un orifice de passage pour le câble et iiiii) un matériau isolant de remplissage sous une forme injectable,
à réaliser les différentes connexions électriques avec le câble au niveau de la carte,
à monter cette dernière longitudinalement dans le boîtier et
à injecter dans ce dernier le matériau de remplissage, partiellement ou en totalité, avant et/ou après mise en place de la pièce d'obturation au niveau de la seconde extrémité dudit boîtier, de manière à enrober ladite carte et ses composants, ainsi que l'extrémité du câble de connexion reliée à ladite carte.

Actuellement, lors de la phase de résinage (injection de matériau de remplissage) et avant mise en place de la pièce d'obturation formant guide câble (bouchon ou capot hermétique et sans trous d'évent), il est nécessaire de laisser lors du résinage, une quantité d'air assez importante et difficilement quantifiable de manière répétée dans le boîtier, afin de permettre l'enfoncement complet de la pièce d'obturation (fermeture étanche).

Cette solution présente l'inconvénient de laisser une quantité assez importante d'air dans le volume intérieur du boîtier.

De ce fait, et au lieu d'aboutir à un enrobage total des composants électroniques, la présence de cet air dans le dispositif, provoque des changements de milieux, qui peuvent notamment induire des risques d'endommagement ou de détérioration de composants et/ou des défauts d'isolement électrique.

En outre, il est souvent avantageux pour ce type de dispositif de pouvoir signaler visuellement un état ou leur état parmi plusieurs états possibles (détection, absence de détection, dysfonctionnement, ...) par une indication lumineuse visible au niveau du boîtier.

La mise en place des moyens de signalisation sur le boîtier ou leur intégration dans la paroi du boîtier est problématique, compte tenu des conditions de montage et des environnements d'utilisation de ces dispositifs.

En effet, dans ces réalisations connues, l'élément lumineux est au moins en partie saillant par rapport au boîtier et nécessite la mise en place d'un moyen de protection transparent additionnel (capuchon ou couvercle). Cette exposition au milieu extérieur, éventuellement aggravée par une proéminence par rapport au boîtier, de l'élément lumineux est extrêmement défavorable : possibilités limitées d'installation, exposition aux chocs, mise à nu de l'alimentation en cas d'arrachement, modification de l'encombrement et de la forme extérieure du boîtier.

Une solution connue peut consister à monter les sources lumineuses des moyens de signalisation à l'intérieur du boîtier et à transmettre les informations lumineuses de signalisation à travers la pièce d'obturation transparente ou translucide.

Toutefois, cette solution est peu efficace (diffusion de lumière, éclairement faible et peu visible de l'ensemble de la pièce, bouchon nécessairement entièrement transparent ou bimatière) et/ou nécessite des pièces additionnelles spécifiques lorsque l'élément lumineux n'est pas à proximité immédiate de la pièce d'obturation (guide-lumière).

Néanmoins, il en résulte alors la nécessité d'un positionnement précis du ou des guide(s) lumière par rapport à la ou aux source(s) et le développement spécifique de guide(s) adapté au type de dispositifs précité, avec obligation de ne pas interférer avec le positionnement précis et le bon enrobage de la carte et de préserver l'intégrité et l'étanchéité du dispositif.

En outre, le document US-A-6 025 562 divulgue différents modes de réalisation d'un dispositif électronique du type précité et d'un procédé de fabrication d'un tel dispositif.

Dans un premier mode de réalisation, décrit en relation avec la figure 35 de ce document et constituant l'état de la technique pour l'enseignement dudit document, un boîtier tubulaire renfermant l'organe de détection reçoit une première quantité d'une première résine, puis une seconde quantité d'une seconde résine. Ensuite, une pièce de fermeture, formant un serre-joint et traversée par le câble de raccordement, est mise en place puis des quantités additionnelles de seconde résine sont successivement injectées à travers l'ouverture de passage du câble. Cette pièce de fermeture comporte une portion de paroi transparente, mais ne comporte pas d'orifice pour l'injection de résine.

Dans les différentes variantes de réalisation d'un second mode de réalisation divulgué par le document US 6 025 562, ressortant des figures 1 à 30, le boîtier renfermant l'organe de détection est obturé par une pièce de fermeture formant un serre-joint et traversée par le câble. Le volume intérieur de l'ensemble est rempli de résine par injection à travers un orifice secondaire prévu dans la pièce de fermeture. Toutefois, cet orifice secondaire n'est pas obturé par un bouchon rapporté, mais par le matériau injecté (finition et aspect extérieur indéfinis). Une portion conductrice de lumière peut être intégrée dans la pièce de fermeture (figure 8), à l'instar du premier mode de réalisation divulgué par US 6 025 562.

Un premier but de l'invention est de proposer une solution simple aux problèmes exposés ci-dessus sans compliquer de manière notable le procédé de fabrication et sans multiplier inutilement les composants, ni complexifier la constitution générale du dispositif concerné.

A cet effet, l'invention a pour objet un procédé de fabrication du type évoqué précédemment, c'est-à-dire en accord avec le préambule de la revendication 1 et présentant en combinaison les caractéristiques de la partie caractérisante de cette revendication 1.

De plus, une difficulté spécifique additionnelle pour la réalisation de ce type de dispositif réside dans la nécessité d'éviter tout contact entre, d'une part, la carte électronique et les composants qu'elle porte et, d'autre part, le boîtier, généralement métallique, pour des raisons électriques (court-circuit, mise à la terre) et mécaniques (chocs, vibrations), tout en favorisant si possible un enrobage optimal de la carte et des composants (limitation des possibles obstacles à la répartition homogène de la résine dans le boîtier et enrobage de la majorité de la carte).

En vue de surmonter cette difficulté additionnelle, l'invention peut prévoir de fournir des moyens coopérants de positionnement de la carte dans le boîtier, préférentiellement de manière centrée et avantageusement avec calage radialement par rapport à la direction longitudinale dudit boîtier, une première partie desdits moyens de positionnement étant présente sur la pièce d'obturation formant guide-câble et l'autre partie, complémentaire, desdits moyens étant présente sur une pièce support montée dans ou sur le boîtier à proximité de la première extrémité de ce dernier.

Selon un mode de réalisation de l'invention, la première partie des moyens de positionnement est constituée par deux portions de rainure opposées, ménagées dans une paroi annulaire ou des portions de paroi opposées respectivement de la pièce d'obturation et de la pièce support et destinées à recevoir avec calage des parties de bords de la carte, cette dernière étant en outre bloquée en position dans la direction de l'axe longitudinal médian du boîtier entre les pièces d'obturation et support.

Afin de permettre un montage simple et notamment sans collage, la pièce d'obturation peut être avantageusement réalisée en un matériau plastique semi-rigide et comporter une paroi annulaire au moins légèrement déformable élastiquement et s'emboîtant avec un contact périphérique étanche dans l'ouverture de la seconde extrémité du boîtier. En outre, l'orifice de passage du câble de connexion est avantageusement décentré par rapport à l'axe longitudinal du boîtier et excentré par rapport à la pièce d'obturation.

En accord avec une variante de réalisation pratique, le bouchon guide-lumière peut comprendre, d'une part, un corps allongé, préférentiellement cylindrique, dont une extrémité libre vient en position à proximité immédiate du au moins un moyen de signalisation lumineuse et, d'autre part, une tête élargie, préférentiellement avec une partie supérieure en forme de dôme, formée au niveau de l'autre extrémité du corps allongé, le second orifice comportant un épaulement adapté pour un emboîtement calé de ladite tête, avantageusement de telle manière que seule la partie en forme de dôme émerge au niveau de la pièce d'obturation et que l'extrémité libre soit positionnée de manière adéquate par rapport au moyen de signalisation.

La paroi en forme de plaque de la pièce d'obturation présente avantageusement une épaisseur suffisante pour loger l'épaulement précité au niveau de la seconde ouverture et pour pouvoir assurer une fonction de guidage du câble de connexion au niveau de la première ouverture.

En outre, le décentrage de l'ouverture du passage du câble permet à ce dernier d'être maintenu latéralement par une portion adjacente de la paroi annulaire de la pièce d'obturation.

Pour autoriser un positionnement du bouchon en face du moyen de signalisation lumineuse et ainsi collecter un maximum de lumière, la carte peut être pourvue d'une découpe autorisant l'engagement du bouchon et son centrage par rapport au moyen précité porté par la carte.

Préférentiellement, la bulle d'air que renferme le boîtier du dispositif est positionnée, après séchage ou réticulation du matériau de remplissage, à distance, d'une part, de la carte électronique et de ses composants et, d'autre part, de la seconde extrémité dudit boîtier, ainsi que des fils de raccordement du câble de connexion ou analogue à la carte (la migration de l'air présent s'effectue essentiellement en début de séchage).

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
la figure 1 est une vue éclatée d'un dispositif électronique, sous la forme d'un capteur inductif, obtenu par le procédé de fabrication selon l'invention ;
les figures 2A et 2B sont des vues en perspective selon deux directions différentes du capteur représenté figure 1 ;
la figure 3A est une vue en élévation latérale du capteur représenté sur les figures 1 et 2 ;
les figures 3B et 3C sont des vues en coupe respectivement selon A-A du capteur représenté figure 3A et selon B-B du capteur représenté figure 3B ;
les figures 4A et 4B sont des vues respectivement de dessus et en coupe selon A-A d'un capteur selon l'une quelconque des figures 1 à 3, installé de manière orientée et indexée sur un support de séchage ;
les figures 5A et 5B sont des vues respectivement de dessous et en coupe selon A-A d'une pièce d'obturation faisant partie du capteur représenté figures 1 à 4 ;
la figure 6 est une vue à une échelle différente du détail B de la figure 5B, et,

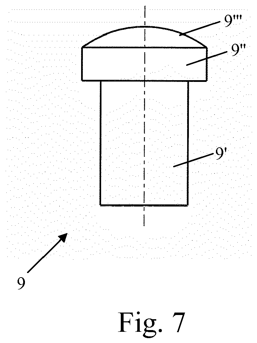

la figure 7 est une vue en élévation latérale du bouchon guide-lumière faisant partie du capteur représenté figures 1 à 4.

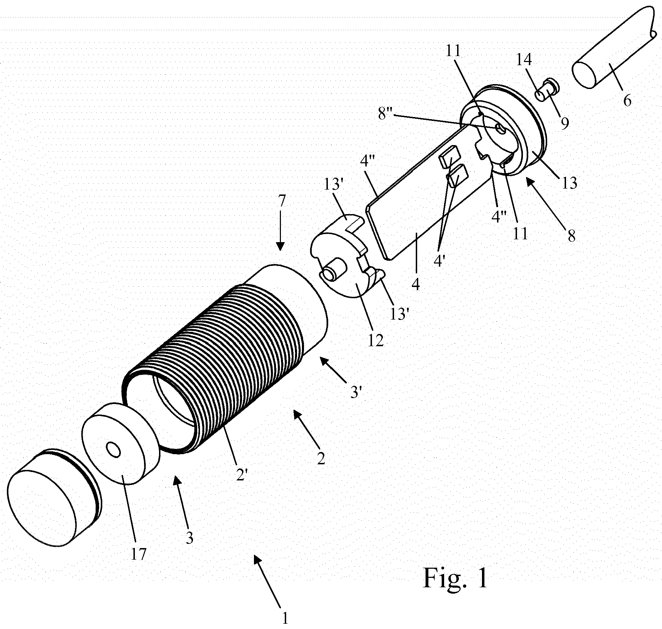

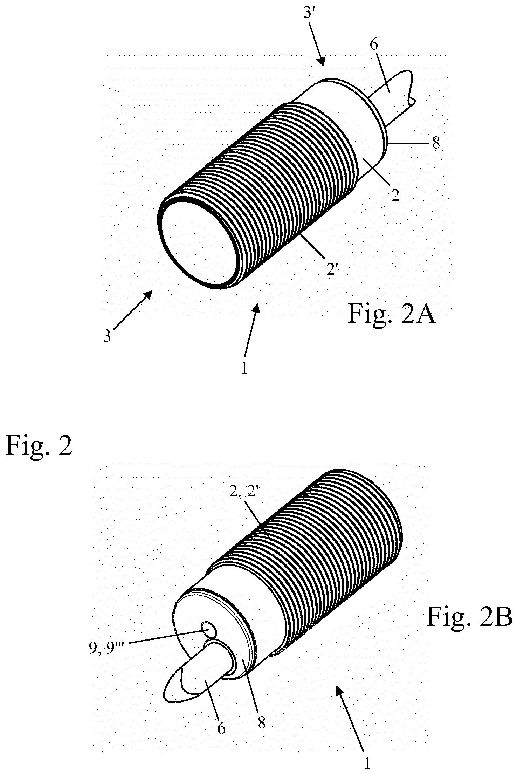

Les figures 1 à 4 notamment des figures annexées illustrent un dispositif électronique 1, notamment du type capteur ou détecteur, comprenant un boîtier 2 sensiblement de forme tubulaire, préférentiellement de section circulaire, présentant des première et seconde extrémités longitudinales 3 et 3' opposées et obturées. Ce boîtier 2 renferme une carte électronique 4 portant des composants 4' et disposée longitudinalement dans ledit boîtier 2, et son volume intérieur est comblé sensiblement en totalité par un matériau isolant de remplissage 5 enrobant ladite carte et ses composants, ainsi que l'extrémité d'un câble de connexion 6 relié à ladite carte. Ce boîtier comporte en outre une ouverture 7 au niveau de sa seconde extrémité 3', laquelle est obturée par une pièce rapportée 8 pourvu d'un orifice de passage 8' pour le câble de connexion.

Ladite pièce d'obturation 8 comporte au moins un second orifice traversant 8" autorisant l'injection de matériau de remplissage 5. Ce ou chaque second orifice 8" est obturé par un bouchon 9 rapporté (pièce fabriquée séparément et montée par emboîtement dans l'orifice 8" qu'il obture) et réalisé en un matériau conduisant et diffusant la lumière, dont une partie est positionnée à proximité, voire en contact, d'au moins un moyen 10 de signalisation lumineuse ou indicateur lumineur porté par la carte 4.

En fournissant une pièce d'obturation 8 avec un orifice 8" d'injection de matériau de remplissage 5 (résine ou analogue) et un bouchon guide-lumière 9 réalisé en un matériau adapté et positionné de manière adéquate, il est possible :
- via la fonction «bouchon»: d'améliorer la qualité du résinage des dispositifs ou produits résultants, en réduisant très significativement la quantité d'air emprisonné dans le boîtier 2 (douille), tout en procurant un bon niveau de finition et un aspect extérieur déterminé et reproductible au produit (pas de résine apparente à la surface du produit).
- via la fonction "guide lumière" : de conduire et de diffuser vers l'extérieur, la lumière produite par un moyen de signalisation ou indicateur lumineux (DEL ou analogue), tout en protégeant efficacement ce dernier, mécaniquement (chocs mécaniques directs) et électriquement (niveau d'isolement électrique), puisqu'il est situé à l'intérieur du boîtier et est lui aussi protégé par de la résine.

Par la prévision de moyens de positionnement 11 au niveau de la pièce d'obturation 8 formant guide-câble, il est possible de réaliser un auto-alignement de la carte 4 par rapport à cette pièce 8 et donc par rapport au bouchon 9 et de garantir un positionnement fiable de la carte 4 dans le boîtier 2.

En effet, les portions de rainure 11 opposées de la pièce 8 dans lesquelles coulissent les bords opposés de la carte 4 (lors de la mise en place de la pièce d'obturation guide câble), assure l'auto-alignement de l'indicateur lumineux 10 (LED simple ou multiple) par rapport au bouchon 9 obturateur et guide lumière, et ainsi une collecte et un guidage optimaux de la lumière transmise à l'extérieur de la douille formant boîtier 2.

De plus, en association avec une pièce 12 support de carte, pourvue de portions de rainure 11', les portions de rainure 11 permettent également de garantir un positionnement répétable de la carte 4 (absence de flexion de la carte 4 liée au câble 6 qui y est raccordé).

Ainsi, la distance d'isolement carte 4/boîtier 2 métallique reste constante et maîtrisée.

Cette disposition permet (selon le niveau d'isolement électrique requis) d'éviter dans la plupart des cas, l'ajout de film isolant à l'intérieur de la douille 2, tout en bénéficiant d'un bon niveau d'isolement électrique, du fait d'un enrobage de résine 5 uniforme et s'étendant tout autour de la carte 4, de ses composants et de ses sites de connexion électrique.

Réalisée dans une matière plastique semi-rigide, la pièce d'obturation 2 formant guide câble/ guide carte est (généralement après le plus gros du résinage) emboité dans l'ouverture 7 du boîtier 2 (douille) sans nécessiter de colle, ce du fait de son élasticité (évitant ainsi toute risque de trace de colle), et tout en assurant une bonne étanchéité, notamment durant la phase de séchage de la résine 5 (absence de fuite de résine).

Il en est de même lors de la mise en place du bouchon obturateur 9 faisant office de guide lumière (par exemple sitôt après la phase finale d'injection de résine). La matière semi-rigide de la pièce 2, assure le maintien du bouchon 9 ainsi que l'étanchéité durant la phase de séchage de la résine.

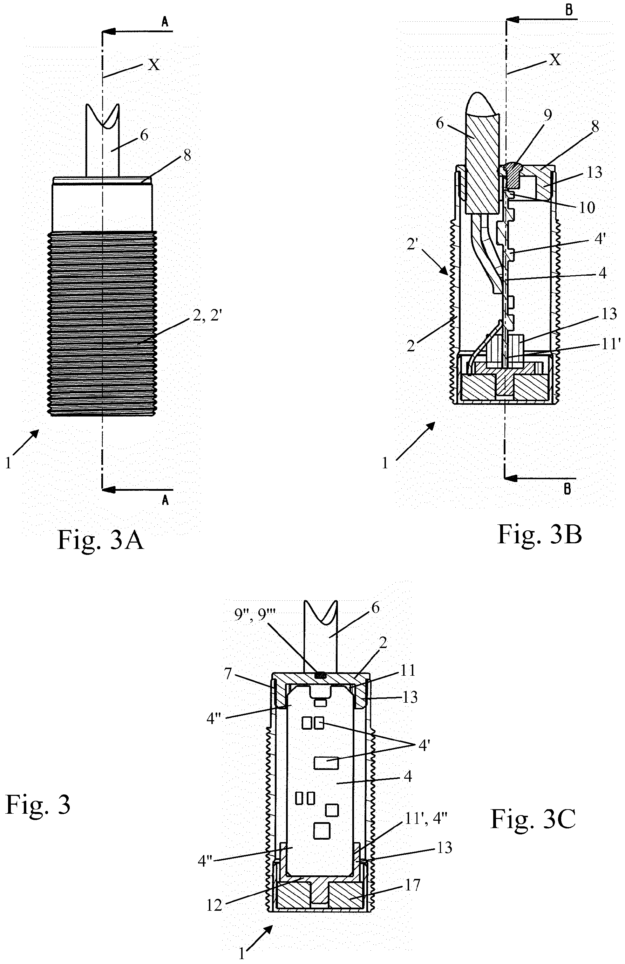

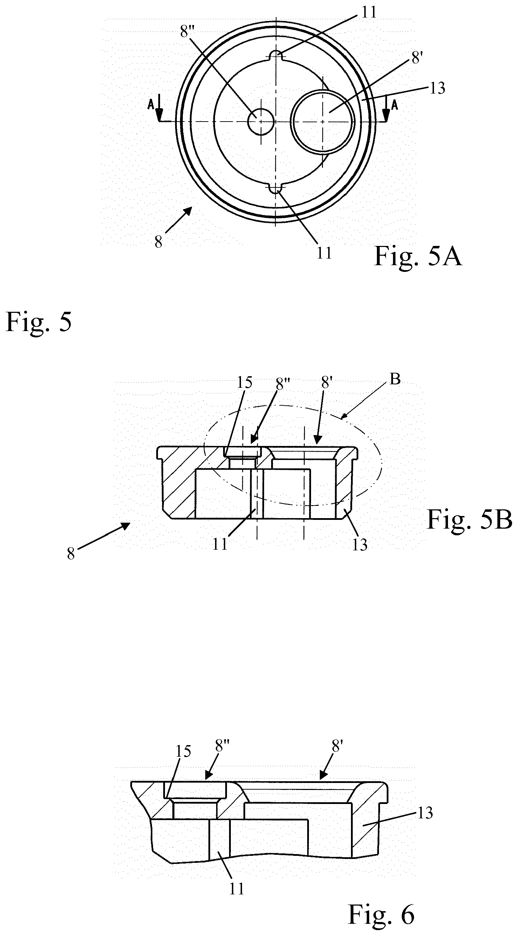

L'épaulement 15 réalisé dans l'orifice 8" de la pièce 8 limite l'enfoncement du bouchon 9 dans le boîtier 2, contribuant ainsi, une fois complètement emboité, à un positionnement précis dudit bouchon 9 par rapport à la DEL 10 de signalisation implantée sur la carte 4 (Fig. 3B, 4B et 6).

Par ailleurs, il est judicieux de ne pas directement situer la surface d'appui du bouchon 9 à la surface de la pièce 8, mais légèrement enfoncée ou en retrait dans ce dernier, ce qui contribue à mieux protéger ledit bouchon 9.

On évite ainsi tout risque d'accroche ou d'arrachement extérieur, et il est ainsi possible de noyer ce bouchon 9 dans la surface de la pièce 8, ce qui améliore également l'esthétique du produit (seule la partie en dôme 9''' de la tête 9" du bouchon 9 est proéminente), tout en fournissant une surface de diffusion lumineuse nettement apparente à l'extérieur (également latéralement à l'axe du produit).

Ce mode d'assemblage propre et économique, simplifie significativement la fabrication des produits et améliore leur fiabilité et leur aspect.

Il convient de noter que la pièce d'obturation 8 peut être mise en place, soit avant résinage (auquel cas toute la résine est introduite par l'orifice de passage 8" du bouchon 9), soit en fin de résinage, afin de déposer rapidement un maximum de résine dans le boitier 2 à travers l'ouverture 7 (la finalisation du résinage ayant lieu dans tous les cas par l'orifice de passage 8", que le bouchon 9 obture au final).

Préférentiellement, comme le montrent les figures 1 à 4, le dispositif 1 consiste en un capteur ou détecteur de présence ou de proximité, par exemple de type inductif, optique, magnétique ou capacitif, dont l'organe fonctionnel 17 définissant la face active est monté au niveau de la première extrémité 3 du boîtier 2, ce dernier se présentant avantageusement sous la forme d'une douille métallique pourvue d'un filetage extérieur 2'.

L'invention permet, grâce à l'intégration dans le boîtier et à l'enrobage complet des composants et de la carte, d'aboutir à une double isolation entre, d'une part, les composants électroniques (inclusivement de signalisation lumineuse) et la carte et, d'autre part, l'extérieur, autorisant une alimentation et un fonctionnement à tension élevée sans risque en cas de rupture ou d'impact.

Comme mentionné précédemment, l'invention a pour objet un procédé de fabrication d'un dispositif 1 tel que décrit ci-dessus.

Ce procédé consiste à fournir un boîtier tubulaire 2, dont une première extrémité 3 est obturée, une carte électronique 4 pourvue de composants 4' adaptés et d'au moins un moyen de signalisation lumineuse 10, un câble de connexion 6, une pièce d'obturation 8 pourvue d'un orifice de passage 8' pour le câble 6 et un matériau isolant de remplissage 5 sous une forme injectable, à réaliser les différentes connexions électriques au niveau de la carte 4, et enfin à monter cette dernière dans le boîtier 2 et à injecter dans ce dernier le matériau de remplissage 5, partiellement ou en totalité, avant et/ou après mise en place de la pièce d'obturation 8 au niveau de la seconde extrémité 3' dudit boîtier 2.

Ce procédé est caractérisé en ce qu'il consiste à prévoir au moins un second orifice 8" dans la pièce d'obturation 8, à injecter la totalité ou au moins une partie complémentaire du matériau de remplissage 5 à travers ce second orifice 8" et à obturer ce second orifice 8" par un bouchon 9 en un matériau conduisant et diffusant la lumière, une partie 14 de ce dernier venant se positionner à proximité, voire en contact, avec ledit au moins un moyen de signalisation lumineuse 10.

Avantageusement, le procédé consiste, après injection du matériau de remplissage 5 et obturation totale de la seconde extrémité 3' du boîtier 2 par mise en place du bouchon 9, à positionner ledit boîtier 2, durant la phase de séchage et/ou de réticulation du matériau injecté, avec une orientation et une indexation telles que la bulle d'air restante 16 soit située à distance, d'une part, de la carte électronique 4 et de ses composants 4', 10 et, d'autre part, de la seconde extrémité 3' dudit boîtier 2, ainsi que des fils de raccordement du câble de connexion 6 ou analogue à la carte 4.

Préférentiellement, le procédé consiste, après mise en place de la carte 4 sur une pièce support 12 montée dans le boîtier 2, à injecter la majorité du matériau de remplissage 5 dans le boîtier 2, puis à mettre en place la pièce d'obturation 8 dans l'ouverture 7 de la seconde extrémité 3' du boîtier 2, ce en calant la carte 4, à injecter ensuite une quantité complémentaire de matériau de remplissage 5 à travers le second orifice 8" de la pièce d'obturation 8, pour combler sensiblement le volume intérieur restant du boîtier 2 à l'exception d'un volume élémentaire légèrement plus grand que le volume du corps 9' du bouchon 9, à mettre en place ledit bouchon guide-lumière 9 de manière à obturer ledit second orifice 8" et enfin à autoriser le séchage ou la réticulation du matériau de remplissage 5 dans une position inclinée et indexée, l'indexation étant déterminée par rapport au câble de connexion 6.

L'homme du métier comprend que, pour autoriser l'introduction du bouchon 9 en fin de résinage, il est nécessaire de réserver une faible quantité d'air dans la douille 2 (supérieur au volume du corps 9' du bouchon).

Pour des raisons esthétiques (pas de bulle d'air à la surface du guide câble) et fonctionnelle (pas de bulle d'air sur la carte électronique 2) il est avantageux de confiner le peu d'air restant, à un endroit précis et répétable, lors de la phase de séchage de la résine 5.

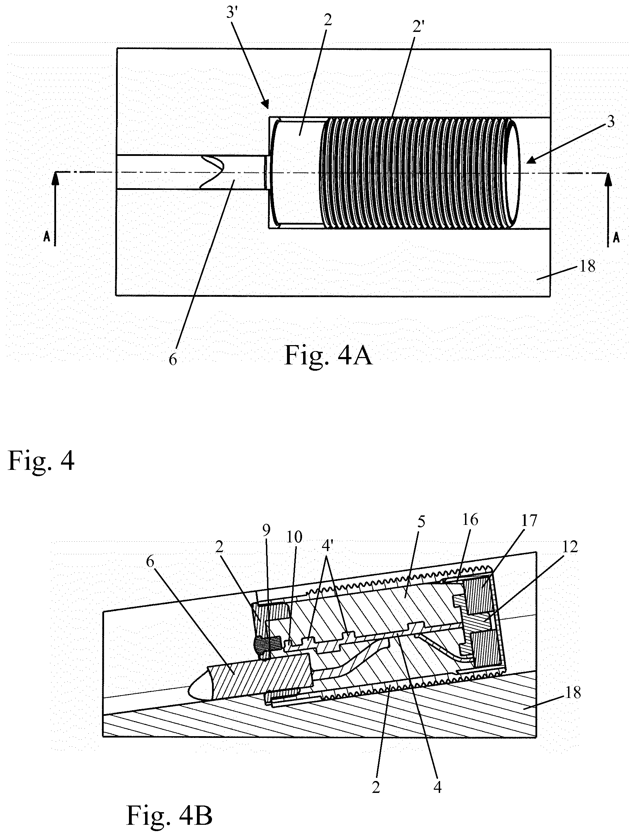

Pour cela, la disposition excentrée de l'orifice de passage 8' du câble 6 dans la pièce 8, contribue au repérage de l'orientation de la carte 4 à l'intérieur de la douille 2. Ainsi, en associant à un tel ensemble, un support de séchage 18 adapté (support procurant de part sa définition une orientation et une inclinaison préférentielle de la douille 2), il est possible de l'extérieur, lors de la phase de séchage de la résine, de maîtriser précisément l'endroit où sera confiné (lors du séchage de la résine), le peu d'air restant 16 (Figures 4A et 4B).

Cet agencement permet de positionner la bulle d'air résiduelle 16 dans une zone absente de composants 4', 10, et de garantir ainsi une bonne imprégnation de résine sur l'ensemble des composants électroniques.

Grâce à l'invention, il est donc notamment possible de :
- Permettre de limiter considérablement la quantité d'air résiduelle lors de la phase de résinage.
- Permettre une bonne transmission et diffusion de la lumière tout en protégeant efficacement l'indicateur lumineux (DEL simple ou multiple).
- Assurer, en combinaison avec un élément guide câble réalisé en matière semi-rigide, un montage simple et sans colle, contribuant à la qualité et à la simplicité d'assemblage des dispositifs 1, ainsi qu'à un positionnement fiable de la carte 4 (en association avec un support de carte 12).

## Revendications

1. Procédé de fabrication d'un dispositif électronique (1), notamment du type capteur ou détecteur, ce procédé consistant à fournir un boîtier (2) tubulaire, préférentiellement de section circulaire, dont une première extrémité (3) est obturée, une carte électronique (4) portant des composants (4') adaptés et au moins un moyen (10) de signalisation lumineuse, un câble de connexion (6), une pièce d'obturation (8) pourvue d'un orifice de passage (8') pour le câble et un matériau isolant de remplissage (5) sous une forme injectable, à réaliser les différentes connexions électriques avec le câble (6) au niveau de la carte (4), à monter cette dernière longitudinalement dans le boîtier (2) et à injecter dans ce dernier le matériau de remplissage, partiellement ou en totalité, avant et/ou après mise en place de la pièce d'obturation (8) au niveau de la seconde extrémité (3') dudit boîtier (2), de manière à enrober ladite carte (4) et ses composants (4'), ainsi que l'extrémité du câble de connexion (6) reliée à ladite carte (4),
procédé **caractérisé en ce qu'**il consiste en outre à prévoir au moins un second orifice (8") dans la pièce d'obturation (8), à injecter la totalité ou au moins une partie complémentaire du matériau de remplissage (5) à travers ce second orifice (8") et à obturer ce second orifice (8") par un bouchon (9) en un matériau conduisant et diffusant la lumière, une partie (14) de ce dernier venant se positionner à proximité, voire en contact, avec ledit au moins un moyen de signalisation lumineuse (10).

2. Procédé de fabrication selon la revendication 1, **caractérisé en ce qu'**il consiste, après injection du matériau de remplissage (5) et obturation totale de la seconde extrémité (3') du boîtier (2) par mise en place du bouchon (9), à positionner ledit boîtier (2), durant la phase de séchage et/ou de réticulation du matériau injecté, avec une orientation et une indexation telles que la bulle d'air restante (16) soit située à distance, d'une part, de la carte électronique (4) et de ses composants (4', 10) et, d'autre part, de la seconde extrémité (3') dudit boîtier (2), ainsi que des fils de raccordement du câble de connexion (6) ou analogue à la carte (4).

3. Procédé de fabrication selon la revendication 1 ou 2, **caractérisé en ce qu'**il consiste, après mise en place de la carte (4) sur une pièce support (12) montée dans le boîtier (2), à injecter la majorité du matériau de remplissage (5) dans le boîtier (2), puis à mettre en place la pièce d'obturation (8) dans l'ouverture (7) de la seconde extrémité (3') du boîtier (2), ce en calant la carte (4), à injecter ensuite une quantité complémentaire de matériau de remplissage (5) à travers le second orifice (8") de la pièce d'obturation (8), pour combler sensiblement le volume intérieur restant du boîtier (2) à l'exception d'un volume élémentaire légèrement plus grand que le volume du corps (9') du bouchon (9), à mettre en place ledit bouchon guide-lumière (9) de manière à obturer ledit second orifice (8") et enfin à autoriser le séchage ou la réticulation du matériau de remplissage (5) dans une position inclinée et indexée, l'indexation étant déterminée par rapport au câble de connexion (6).

4. Procédé selon l'une quelconque des revendications 1 à 3, **caractérisé en ce qu'**il consiste à fournir des moyens coopérants (11, 11') de positionnement de la carte (4) dans le boîtier (2), préférentiellement de manière centrée et avantageusement avec calage radialement par rapport à la direction longitudinale (X) dudit boîtier (2), une première partie (11) desdits moyens de positionnement étant présente sur la pièce d'obturation (8) formant guide-câble et l'autre partie (11'), complémentaire, desdits moyens étant présente sur une pièce support (12) montée dans ou sur le boîtier (2) à proximité de la première extrémité (3) de ce dernier.

5. Procédé selon la revendication 4, **caractérisé en ce qu'**il consiste à fournir des moyens de positionnement (11, 11') constitués par deux portions de rainure opposées, ménagées dans une paroi annulaire (13) ou des portions de paroi opposées (13') respectivement de la pièce d'obturation (8) et de la pièce support (12) et destinées à recevoir avec calage des parties de bords (4") de la carte (4), cette dernière étant en outre bloquée en position dans la direction de l'axe longitudinal médian (X) du boîtier (2) entre les pièces (8, 12) d'obturation et support.

6. Procédé selon l'une quelconque des revendications 1 à 5, **caractérisé en ce qu'**il consiste à réaliser la pièce d'obturation (8) en un matériau plastique semi-rigide et avec une paroi annulaire (13) au moins légèrement déformable élastiquement et s'emboîtant avec un contact périphérique étanche dans l'ouverture (7) de la seconde extrémité (3') du boîtier (2) et **en ce qu'**il consiste à décentrer l'orifice de passage (8') du câble de connexion (6) par rapport à l'axe longitudinal (X) du boîtier (2) et à l'excentrer par rapport à la pièce d'obturation (8).

7. Procédé selon l'une quelconque des revendications 1 à 6, **caractérisé en ce qu'**il consiste à fournir un bouchon guide-lumière (9) comprenant, d'une part, un corps allongé (9'), préférentiellement cylindrique, dont une extrémité libre (14) vient en position à proximité immédiate du au moins un moyen de signalisation lumineuse (10) et, d'autre part, une tête élargie (9"), préférentiellement avec une partie supérieure en forme de dôme (9'''), formée au niveau de l'autre extrémité du corps allongé (9'), le second orifice (8") comportant un épaulement (15) adapté pour un emboîtement calé de ladite tête (9"), avantageusement de telle manière que seule la partie en forme de dôme (9''') émerge au niveau de la pièce d'obturation (8) et que l'extrémité libre (14) soit positionnée de manière adéquate par rapport au moyen de signalisation (10).

8. Procédé selon l'une quelconque des revendications 1 à 7, **caractérisé en ce qu'**il consiste à monter l'organe fonctionnel (17) définissant la face active au niveau de la première extrémité (3) du boîtier (2), ce dernier se présentant avantageusement sous la forme d'une douille métallique pourvue d'un filetage extérieur (2'), le dispositif électronique (1) consistant en un capteur ou détecteur de présence ou de proximité, par exemple de type inductif, optique, magnétique ou capacitif.

## Patentansprüche

1. Verfahren zur Herstellung eines elektronischen Geräts (1), insbesondere vom Typ Sensor oder Detektor, wobei dieses Verfahren darin besteht, ein rohrförmiges Gehäuse (2) vorzugsweise kreisförmigen Querschnitts bereitzustellen, dessen erstes Ende (3) verschlossen ist, eine Leiterplatte (4), die angepasste Komponenten (4') und mindestens ein Leuchtanzeigemittel (10) trägt, ein Anschlusskabel (6), ein Verschlussstück (8) mit einer Durchtrittsöffnung (8') für das Kabel und einen isolierenden Füllwerkstoff (5) in einspritzbarer Form, um die verschiedenen elektrischen Verbindungen des Kabels (6) mit der Platte (4) herzustellen, diese letztere in Längsrichtung im Gehäuse (2) zu montieren und vor und/oder nach dem Einsetzen des Verschlussstückes (8) ins zweite Ende (3') des genannten Gehäuses (2) in dieses letztere den Füllwerkstoff teilweise oder vollständig einzuspritzen, um die genannte Platte (4) und ihre Komponenten (4'), sowie das Ende des Verbindungskabels (6), das an der genannten Platte (4) angeschlossen ist, einzubetten,
Verfahren, **dadurch gekennzeichnet, dass** es außerdem darin besteht, mindestens eine zweite Öffnung (8") im Verschlussstück (8) vorzusehen, um die Gesamtheit oder mindestens einen zusätzlichen Teil des Füllwerkstoffes (5) durch diese zweite Öffnung (8") einzuspritzen, und diese zweite Öffnung (8") durch einen Stopfen (9) aus lichtleitendem und -streuendem Werkstoff zu verschließen, wobei ein Teil (14) dieses letzteren in die Nähe des oder in Berührung mit dem genannten mindestens einen Lichtanzeigeelement (10) gelangt.

2. Herstellungsverfahren nach Patentanspruch 1, **dadurch gekennzeichnet, dass** es darin besteht, nach Einspritzen des Füllwerkstoffes (5) und vollständigem Verschluss des zweiten Endes (3') des Gehäuses (2) durch Einsetzen des Stopfens (9) das genannte Gehäuse (2) während der Trocknungs- und/oder Vernetzungsphase des eingespritzten Werkstoffes mit einer derartigen Orientierung und Ausrichtung anzuordnen, dass sich die verbleibende Luftblase (16) fern von einerseits der Leiterplatte (4) und ihren Komponenten (4', 10) und andererseits dem zweiten Ende (3') des genannten Gehäuses (2), sowie den Anschlussdrähten des Anschlusskabels (6) oder Ähnlichem an der Platte (4) befindet.

3. Herstellungsverfahren nach Patentanspruch 1 oder 2, **dadurch gekennzeichnet, dass** es darin besteht, nach dem Anordnen der Platte (4) auf einem im Gehäuse (2) angebrachten Tragteil (12) den größten Teil des Füllwerkstoffes (5) ins Gehäuse (2) einzuspritzen, dann das Verschlussstück (8) in die Öffnung (7) des zweiten Endes (3') des Gehäuses (2) einzusetzen, wobei die Platte (4) festgeklemmt wird, dann eine zusätzliche Menge Füllwerkstoffes (5) durch die zweite Öffnung (8") des Verschlussstückes (8) einzuspritzen, um im Wesentlichen den verbleibenden Innenraum des Gehäuses (2) mit Ausnahme eines geringen Volumens auszufüllen, das geringfügig größer ist, als das Volumen des Körpers (9') des Stopfens (9), den genannten Lichtleiterstopfen (9) derart einzusetzen, dass die genannte zweite Öffnung (8") verschlossen wird, und schließlich die Trocknung oder Vernetzung des Füllwerkstoffes (5) in einer geneigten und ausgerichteten Stellung zu erlauben, wobei die Ausrichtung relativ zum Anschlusskabel (6) festgelegt wird.

4. Verfahren nach irgendeinem der Patentansprüche 1 bis 3, **dadurch gekennzeichnet, dass** es darin besteht, zusammenwirkende Mittel (11, 11') zur Positionierung der Karte (4) im Gehäuse (2) bereitzustellen, vorzugsweise zentriert und vorteilhafterweise mit radialer Festklemmung relativ zur Längsrichtung (X) des genannten Gehäuses (2), wobei sich ein erster Teil (11) der genannten Positionierungsmittel am als Kabelführung dienenden Verschlussstück (8) befindet und sich der andere, komplementäre Teil (11') der genannten Mittel auf einem Tragstück (12) befindet, das in oder am Gehäuse (2) nahe dem ersten Ende (3) dieses letzteren angebracht ist.

5. Verfahren nach Patentanspruch 4, **dadurch gekennzeichnet, dass** es darin besteht, Positionierungsmittel (11, 11') bereitzustellen, die aus zwei gegenüberliegenden Rillenabschnitten bestehen, die in einer ringförmigen Wand (13) ausgebildet sind oder in Teilen gegenüberliegender Wände des Verschlussstückes (8) und des Tragstückes (12) und dazu bestimmt sind, Randteile (4") der Platte (4) einklemmend aufzunehmen, wobei diese letztere außerdem in Richtung der Längsmittelachse (X) des Gehäuses (2) zwischen den Verschluss- und Tragstücken (8, 12) in ihrer Stellung festgesetzt ist.

6. Verfahren nach irgendeinem der Patentansprüche 1 bis 5, **dadurch gekennzeichnet, dass** es darin besteht, das Verschlussstück (8) aus einem halbstarren Kunststoff und mit einer mindestens geringfügig elastisch verformbaren ringförmigen Wand (13) zu fertigen, die mit abdichtender peripherer Berührung in die Öffnung (7) des zweiten Endes (3') des Gehäuses (2) passt und dadurch, dass es darin besteht, die Durchtrittsöffnung (8') des Anschlusskabels (6) relativ zur Längsachse (X) des Gehäuses (2) dezentriert auszubilden und exzentrisch relativ zum Verschlussstück (8).

7. Verfahren nach irgendeinem der Patentansprüche 1 bis 6, **dadurch gekennzeichnet, dass** es darin besteht, einen lichtdurchlässigen Stopfen (9) bereitzustellen, der einerseits einen länglichen, vorzugsweise zylindrischen Körper (9') umfasst, dessen eines freies Ende (14) in unmittelbarer Nähe des mindestens einen Leuchtanzeigemittels (10) in Stellung kommt, und andererseits einen erweiterten Kopf (9"), vorzugsweise mit einem oberen, gewölbten Teil (9'''), der am anderen Ende des länglichen Körpers (9') ausgeformt ist, wobei die zweite Öffnung (8") eine Schulter (15) aufweist, die für ein festgeklemmtes Einsetzen des genannten Kopfes (9") ausgelegt ist, vorteilhafterweise derart, dass nur der gewölbte Teil (9''') im Bereich des Verschlusssstücks (8) herausragt und dass das freie Ende (14) in passender Weise relativ zum Anzeigemittel (10) positioniert ist.

8. Verfahren nach irgendeinem der Patentansprüche 1 bis 7, **dadurch gekennzeichnet, dass** es darin besteht, das Funktionsorgan (17), das die aktive Seite festlegt, im Bereich des ersten Endes (3) des Gehäuses (2) anzubringen, wobei dieses letztere vorteilhafterweise die Form einer Metallhülse aufweist, die mit einem Außengewinde (2') versehen ist, wobei das elektronische Gerät (1) in einem Anwesenheits- oder Annäherungssensor oder -detektor beispielsweise vom induktiven, optischen, magnetischen oder kapazitiven Typ besteht.

## Claims

1. Method for manufacturing an electronic device (1), in particular of sensor or detector type, this method consisting in providing a tubular housing (2), preferably having a circular cross section and a first end (3) of which is blocked off, an electronic board (4) bearing suitable components (4') and at least one luminous signalling means (10), a connecting cable (6), a blocking component (8) provided with a through-orifice (8') for the cable and an insulating filler material (5) in an injectable form, in producing the various electrical connections with the cable (6) on the board (4), in mounting said board longitudinally in the housing (2) and in partly or fully injecting the filler material into said housing before and/or after the blocking component (8) has been installed at the second end (3') of said housing (2) so as to encapsulate said board (4) and its components (4') and also that end of the connecting cable (6) that is linked to said board (4),
which method is **characterized in that** it furthermore consists in providing at least one second orifice (8") in the blocking component (8), in injecting all or at least an additional portion of the filler material (5) through this second orifice (8") and in blocking off this second orifice (8") using a stopper (9) made of a light-conductive and light-diffusing material, a portion (14) of said stopper being positioned in the proximity of, or even in contact with, said at least one luminous signalling means (10).

2. Manufacturing method according to Claim 1, **characterized in that** it consists, after injection of the filler material (5) and complete blocking off of the second end (3') of the housing (2) through installation of the stopper (9), in positioning said housing (2), during the phase of drying and/or of crosslinking of the injected material, with an orientation and an indexation that are such that the remaining bubble of air (16) is situated at a distance firstly from the electronic board (4) and its components (4', 10) and secondly from the second end (3') of said housing (2), and also from the wires for connecting the connecting cable (6) or the like to the board (4).

3. Manufacturing method according to Claim 1 or 2, **characterized in that** it consists, after installation of the board (4) on a carrier component (12) mounted in the housing (2), in injecting the majority of the filler material (5) into the housing (2), and then in installing the blocking component (8) in the aperture (7) of the second end (3') of the housing (2), this being achieved by inserting the board (4), in thereafter injecting an additional amount of filler material (5) through the second orifice (8") of the blocking component (8) in order to substantially fill the remaining internal volume of the housing (2) with the exception of a basic volume slightly larger than the volume of the body (9') of the stopper (9), in installing said light-guiding stopper (9) in such a way as to block off said second orifice (8"), and lastly in allowing the filler material (5) to dry or crosslink in an inclined and indexed position, the indexation being determined with respect to the connecting cable (6).

4. Method according to any one of Claims 1 to 3, **characterized in that** it consists in providing interacting means (11, 11') for positioning the board (4) in the housing (2), preferably in a centred manner and advantageously with insertion radially with respect to the longitudinal direction (X) of said housing (2), a first portion (11) of said positioning means being present on the blocking component (8) forming a cable guide and the other, complementary, portion (11') of said means being present on a carrier component (12) mounted in or on the housing (2) in the proximity of the first end (3) of said housing.

5. Method according to Claim 4, **characterized in that** it consists in providing positioning means (11, 11') that are formed by two opposing groove portions arranged in an annular wall (13) or opposing wall portions (13'), respectively, of the blocking component (8) and of the carrier component (12) and intended to receive, through insertion, edge portions (4'') of the board (4), said board furthermore being locked in position in the direction of the median longitudinal axis (X) of the housing (2) between the blocking and carrier components (8, 12).

6. Method according to any one of Claims 1 to 5, **characterized in that** it consists in producing the blocking component (8) from a semi-rigid plastic material and with an annular wall (13) that is at least slightly elastically deformable and slots, with a sealing peripheral contact, into the aperture (7) of the second end (3') of the housing (2), and **in that** it consists in decentring the through-orifice (8') for the connecting cable (6) with respect to the longitudinal axis (X) of the housing (2) and in offsetting it with respect to the blocking component (8).

7. Method according to any one of Claims 1 to 6, **characterized in that** it consists in providing a light-guiding stopper (9) comprising firstly an elongated body (9') that is preferably cylindrical and a free end (14) of which is positioned in the immediate proximity of the at least one luminous signalling means (10) and secondly an enlarged head (9"), preferably with a dome-shaped upper portion (9'''), formed at the other end of the elongated body (9'), the second orifice (8") having a shoulder (15) suitable for a slotted insertion of said head (9"), advantageously such that only the dome-shaped portion (9''') emerges at the blocking component (8) and that the free end (14) is positioned in a suitable manner with respect to the signalling means (10).

8. Method according to any one of Claims 1 to 7, **characterized in that** it consists in mounting the functional member (17) defining the active face at the first end (3) of the housing (2), said housing advantageously taking the form of a metal sleeve provided with an external thread (2'), the electronic device (1) consisting of a presence or proximity sensor or detector, for example of inductive, optical, magnetic or capacitive type.
